**Europäisches Patentamt**

**European Patent Office**

**Office européen des brevets**

(19)

(11) Publication number : **0 095 743 B2**

# NEW EUROPEAN PATENT SPECIFICATION

(12)

(45) Date of publication of the new patent specification : **27.05.92 Bulletin 92/22**

(51) Int. Cl.⁵ : **E05D 3/06,** E06B 5/18, H05K 9/00

(21) Application number : **83105241.0**

(22) Date of filing : **26.05.83**

(54) **Door in a construction preventing the transition of interference fields.**

(30) Priority : **28.05.82 FI 821904**

(43) Date of publication of application : **07.12.83 Bulletin 83/49**

(45) Publication of the grant of the patent : **19.10.88 Bulletin 88/42**

(45) Mention of the opposition decision : **27.05.92 Bulletin 92/22**

(84) Designated Contracting States : **BE CH DE FR GB IT LI NL SE**

(56) References cited :
**DE-A- 1 933 557**
**DE-A- 2 630 121**
**DE-C- 623 854**
**DE-C- 654 733**
**DE-C- 976 848**

(56) References cited :
**DE-U- 1 914 503**
**GB-A- 254 061**
**GB-A- 487 579**
**US-A- 364 753**
**US-A- 2 535 324**
**US-A- 3 055 969**
**US-A- 3 681 873**
**US-A- 3 758 919**
**US-A- 4 262 447**

(73) Proprietor : **EUROSHIELD OY**
**SF-27510 Eura (FI)**

(72) Inventor : **Sohlström, Lasse**
**SF-27510 Eura (FI)**

(74) Representative : **Grams, Klaus Dieter, Dipl.-Ing. et al**
**Patentanwaltsbüro Tiedtke-Bühling-Kinne-Grupe-Pellmann-Grams-Struif Winter-Roth**
**Bavariaring 4**
**W-8000 München 2 (DE)**

EP 0 095 743 B2

## Description

The present invention is concerned with a door in accordance with the preamble of claim 1 in a construction preventing the transition of interference fields, in particular of high-frequency electromagnetic fields.

The function of constructions used in order to provide an interference-protected space may be to prevent penetration of external electromagnetic energy into the protected space, or to confine electromagnetic energy within the space enclosed by the construction by preventing leakage of the interference field to the environment. Constructions of this type are known in prior art, and they are used commonly in order to protect sensitive equipment from electromagnetic radiation and to permit the performance of measurements free from radio-frequency interference in industry employing data communication technology and high-frequency technology, in research, as well as, e.g., in hospitals. Irrespective of the purpose of use of the protected space, the part of the protection with the poorest attenuation is usually made by the contact zone between the openable door, window, gate or equivalent, which is necessary for access into the protected space, and the solid stationary construction. In order to avoid the effect of deteriorating of the properties of protection of the door, the electrical contact between the mobile part of the door and the door frame and, in the case of protection from low-frequency magnetic field, the reluctance path must be as continuous as possible and correspond to the properties of the rest of the construction. The attenuating properties of the joint between the door and the frame can, above all at high frequencies, be improved by means of a labyrinth structure placed at the contact zone, where, in order to guarantee contact, the knife-shaped contact tongues on the door are pressed in between contact springs fitted in a groove passing around the door opening as disclosed in US-A-3,681,873.

The performance values obtained in practice by means of prior-art door solutions have, however, been limited by the fact that in particular a multiple labyrinth structure has not been possible in use owing to the necessary tight tolerances, while at the same time retaining a normal operating ease of the door and the properties of operation of a normally hinged door. When an efficient and complicated labyrinth structure is used, owing to the tight tolerances the contact tongues penetrating between the springs tend to damage the seal construction by, by the effect of the pivoting movement of the normally hinged door, prying the seal springs out of position, and, on the other hand, the closing of the door requires a very high compression force, e.g. 300 to 400 kp.

Thus, the object of the invention is to avoid the above drawbacks related to the doors of electromagnetically protected spaces and to provide a simple and inexpensive door system by means of which performance values better than so far are obtained in respect of the attenuation of the interference field and whose operation in respect of the ease of using, however, as far as possible corresponds to a normal door so that the door can be opened rapidly and easily without handling of extra locking and compression means, which make rapid opening of the door difficult, e.g., in cases of emergency.

A particularly advantageous embodiment of the invention is obtained when the substantially linear movement, when producing the contact that prevents the transition of the interference field, is accomplished as guided by the locking means interconnecting the door and the stationary construction and when the operation of the locking means is, by means of lever equipment, connected to the door handle.

The other properties and details of the preferred embodiment of the invention come out from the following description related to the attached drawing. Even though the invention is therein described in relation to a door, it is evident that the invention may equally well be in connection with an openable window or gate, all of which are supposed to be included in the scope of the invention defined in the patent claims given below.

In the drawing,

Figure 1 shows the labyrinth structure and the hinge device of the preferred embodiment of the door in accordance with the invention as a horizontal section,

Figure 2 shows the locking means and lever equipment producing the linear movement of the door in accordance with the invention,

Figures 3 and 4 show horizontal sections along lines III-III and IV-IV in Fig. 2, and

Figure 5 shows the diagonal slot in the frame and the running roll in the closed position of the door.

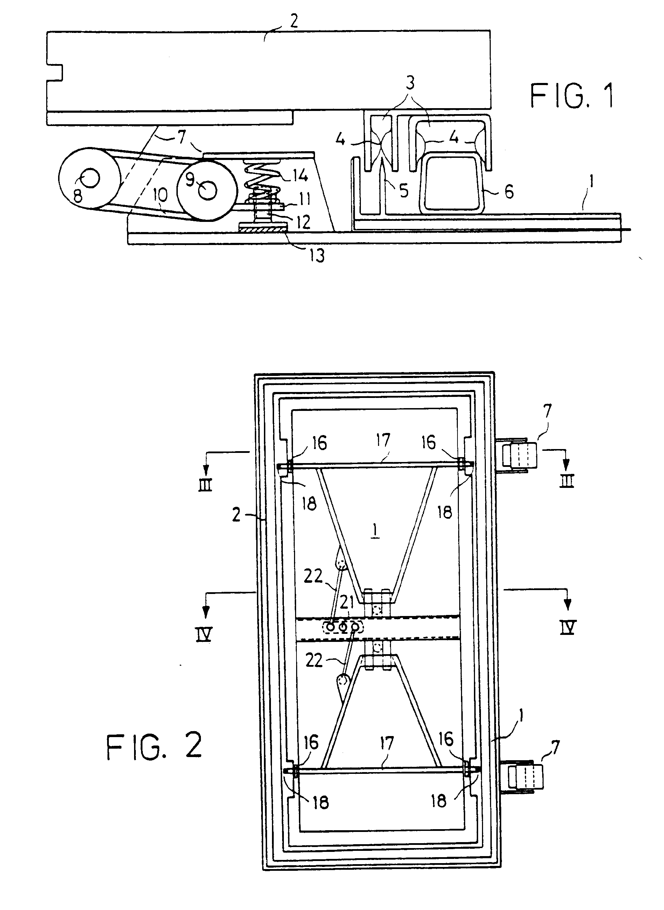

Figure 1, which is an illustration of a horizontal section of the hinge-side door edge and of the frame, shows the embodiment of the labyrinth structure passing around the edge of the door, which door is generally denoted with 1, and the frame 2. In the embodiment shown, the frame 2 is provided with slots 3 of substantially rectangular section, made, e.g., of profiles of appropriate

This problem is solved, according to the invention, by the features specified in the characterising portion of claim 1.

In the construction according to the invention, when the door is being closed the contact knife is easily pushed between the contact springs owing to the structure and the attachement mode of the contact spring.

When the door is closed according to US 3 758 919, a small lateral movement occurs simultaneously, said movement serving for the cleaning of the sealing surfaces (see US 3 758 919, col.4, 2nd paragraph).

Thus it is only by a linear movement without any lateral movement and by the simultaneous guidance of the door by means of the wedge-shaped guide in the slot that a high precision in the movement of the door is obtained so that damage is avoided. To the seal construction electrically conductive material. The opposite side walls of the slots 3 are provided with springs 4 functioning as seals and made, e.g., of Be-bronze. When the door is being closed, the springs 4 receive between them the components of the labyrinth structure connected to the door 1, the said components comprising a tongue-shaped contact knife 5 placed closer to the edge of the door and a guide 6 of wedge-shaped section. The function of the springs 4, whose number is four in the embodiment shown, is to form an electrical contact as good as possible between the contact knife 5 or the guides 6 and the walls of the slot 3 as well as, also to guide the guide 6 of wedge-shaped section precisely in position when the door is being closed. Owing to the tight tolerances required for reliable contact and guiding, the pressing of the contact knife 5 and of the guide 6 between the contact springs 4 for the purpose of closing the door 1 further from the position shown in Fig. 1 is not performed by means of the normal pivoting movement of the door, but, when the door is being closed, the final portion, about 2 cm, of the movement of the contact knife 5 and of the guide 6 takes place, according to the invention, linearly in a direction perpendicular to the plane of the door.

The linear final movement of the door can be accomplished by means of a two-shaft hinge device 7 in accordance with Fig. 1, in which a pivot shaft 8 is journalled in the part of the hinge device attached to the frame 2 and another pivot shaft 9, permitting the linear movement, is journalled in the part of the hinge device attached to the mobile part of the door. The pivot shafts 8 and 9 are connected to each other by means of an arm 10. The pivoting movement of the door 1 around the shaft 9 is restricted by means of an arrangement shown in the figure, which arrangement comprises a screw 12 threaded into a projection 11 connected to the arm 10, the head of the said screw 12 being formed as a stop provided with a rubber cushion 13. The spring 14 presses the door against the limiter, and the distance of the stop 13 from the projection 11 and, consequently, the position of the door 1, can be adjusted by means of the screw 12.

Figures 2 to 5 illustrate devices which produce the compression force required by the linear movement in accordance with the invention, the said linear movement producing the tight contact between the door 1 and the stationary construction 2, which said devices consist of jointly operative door and frame locking means connecting the door and the stationary construction to each other as well as of a system of levers controlling the locking means.

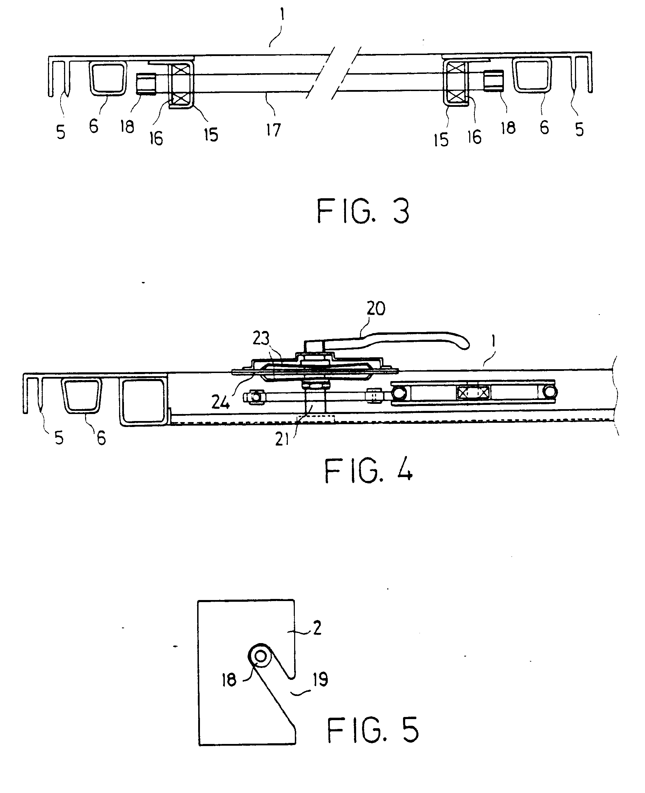

The locking means contained in the door 1 comprise pulling shafts 17 mounted behind the front sheet in the frame of the door as vertically displaceable by means of U-rails 15 and bearings 16. At the ends of these pulling shafts 17, running rolls 18 have been journalled as positioned in pairs symmetrically in relation to the longitudinal and latitudinal axes of the door, the said rolls 18 being, when the door is being closed, jointly operative with the diagonal slots 19, shown in Fig. 5, forming the locking means in the stationary construction. For the purpose of controlling the operation of the locking means, the movement of the pulling shafts 17 is, by the intermediate of a system of levers of conventional construction, shown in Fig. 2, connected to the turning movement of the shaft 21 of the door handle 20 so that the pulling shafts 17 move, being shifted by the rods 22, in opposite directions when the handle 20 is being turned.

As comes out from Fig. 4, the transition of the interference field into the protected space through the turning shaft 21 of the handle 20, passing through the front sheet of the door, is prevented by means of a contact disc 23 of an electrically highly conductive material, attached to the shaft 21, the face of the said disc rubbing against the disc 24 placed underneath and attached to the front sheet of the door when the handle 20 is being turned.

When the door is being closed, the pulling shafts 17 and the lever system are initially in the position shown in Fig. 2. The closing of the door is started by shifting the door 1 by a normal pivoting movement around the pivot shafts 8 of the hinge devices 7 into the position shown in Fig. 1, in which position the guide 6 and the contact knife 5 meet the springs 4 and the pivoting movement around the shaft 8 is ended. In this position, the running rolls 18 become positioned at the initial ends of the respective diagonal slots 19 placed at the frame 2 at both sides. For this purpose, the angle of the door 1 in relation to the frame 2 is adjustable by means of the screws 12 at the stops of the hinge devices 7. The power required in order to continue the closing movement as a linear movement is hereinafter generated by turning the handle 20 downwards so that the pulling shafts 17 and the roll pairs 18 journalled thereon move away from each other and, guided by the diagonal slots 19 in the frame 2, towards the position shown in respect of the upper pair of rolls in Fig. 5. The shafts 8 and 9 of the hinge devices 7 rotate in opposite directions, eliminating any lateral movement of the door, and the rolls 18 and the pulling shafts 17, which are positioned symmetrically, pull the door 1, guided by the guides 6, into contact with the seal structure in the frame 2 in a direction perpendicular to the plane of the door.

Even though the invention has been, above, described in relation to a certain preferred embodiment, the construction described may be varied in many ways without departing from the scope of the invention. Thus, for example, the design of the labyrinth structure and the number of springs and contact knives may vary, and the locking means of the door and frame may also differ from those described above and from the solution illustrated in the drawing.

## Revendications

1. A door in a construction preventing the transition of interference fields, in particular of high-frequency electromagnetic fields,
wherein said door (1) is mounted pivotably by means of at least one hinge device (7),
said door (1) and said stationary construction (2) being provided with contact means (3, 4, 5,) which produce a contact between said door (1) and said stationary construction (2) preventing the transition of interference fields, said contact means comprising one slot (3) provided on the frame and having a substantially rectangular cross section,
springs (4) provided on opposite inner sidewalls of said slot (3), and
a tongue-shaped contact knife (5) connected to said door (1) close to the edge thereof and insertable into said slot (3), **characterized in**
**that** the movement of said door (1) for opening or closing said construction (2) is split up into two phases in a manner known per se, one phase of which consists of the pivoting movement around axes (8) defined by said hinge device (7) and the other phase of which consists of a substantially linear movement perpendicular to the frame of said door (1), and
**that** said contact means further comprise a wedge-shaped guide (6) connected to said door (1) and insertable into a second slot (3),
wherein said substantially linear movement is a guided linear movement without any lateral movement.

2. A door as claimed in claim 1, characterized in that the substantially linear movement of the door (1), when producing the contact that prevents the transition of the interference field, is accomplished as guided by a locking means (18, 19) interconnecting the door (1) and the stationary construction (2).

3. A door as claimed in claim 2, characterized in that the operation of the locking means (18, 19) is, by means of lever equipment (16, 17, 21, 22), connected to the door handle (20).

4. A door as claimed in claim 2 or 3, characterized in that the locking means comprise a set of first locking members (17, 18) placed in the door and moving in a direction parallel to the plane of the face of the door in opposite directions as well as a set of second locking members (19) placed in the stationary construction, jointly operative with the said first members and producing a force perpendicular to the plane of the door face.

5. A door as claimed in claim 4, characterized in that the first locking members comprise running rolls (18) journalled at the ends of the pulling shafts (17) moving in opposite directions in a direction parallel to the plane of the door face and that the second locking members jointly operative with the said first members comprise diagonal slots (19) connected to the stationary construction (2) and guiding the running rolls (18).

6. A door as claimed in any of the preceding claims, characterized in that it is mounted on the stationary construction (2) by means of hinges (7) provided with two shafts and permitting a linear movement.

7. A door as claimed in claim 6, characterized in that the pivoting movement of the door around one shaft (9) of the hinge (7) permitting linear movement is limited by means of a spring-loaded (14) adjustable limiter (13).

## Patentansprüche

1. Eine Tür in einer den Übergang von Störfeldern, insbesondere von hochfrequenten elektromagnetischen Feldern, verhindernden Konstruktion,
wobei die besagte Tür (1) gelenkig mittels wenigstens einer Scharniervorrichtung (7) gelagert ist,
die besagte Tür (1) sowie die erwähnte stationäre Konstruktion (2) mit Kontakteinrichtungen (3, 4, 5) versehen sind, welche einen den Übergang von Störfeldern verhindernden Kontakt zwischen der besagten Tür (1) sowie der erwähnten stationären Konstruktion (2) herstellen,
die genannten Kontakteinrichtungen umfassen einen an dem Rahmen vorgesehenen und einen im wesentlichen rechteckigen Querschnitt aufweisenden Schlitz (3),
an gegenüberliegenden inneren Seitenwänden des genannten Schlitzes (3) vorgesehene Federn (4) und ein mit der besagten Tür (1) nahe deren Kante verbundenes sowie in den genannten Schlitz (3) einsetzbares zungenförmiges Kontaktmesser (5),
dadurch gekennzeichnet,
daß die Bewegung der besagten Tür (1) zum Öffnen und Schließen der erwähnten Konstruktion (2) in an sich bekannter Weise in zwei Phasen aufgeteilt ist, deren eine Phase in der Schwenkbewegung um von der genannten Scharniervorrichtung (7) bestimmte Achsen (8) herum besteht und deren andere Phase in einer im wesentlichen linearen, zu dem Rahmen der besagten Tür (1) rechtwinkligen Bewegung besteht, und
daß die genannten Kontakteinrichtungen ferner eine keilförmige, mit der besagten Tür (1) verbundene sowie in einen zweiten Schlitz (3) einsetzbare Führung (6) umfassen,
wobei die erwähnte, im wesentlichen lineare Bewegung eine geführte lineare Bewegung ohne jede seitliche Bewegung ist.

2. Tür nach Anspruch 1, dadurch gekennzeichnet, daß die etwa geradlinige Bewegung der Tür (1) bei der Herstellung des Kontakts, der den Durchgang der Interferenzfelder verhindert, vervollständigt wird, indem sie durch eine Verriegelungsvorrichtung (18, 19) geführt wird, die die Tür (1) und das ortsfeste Gebäudeteil 12) miteinander verbindet.

3. Tür nach Anspruch 2, dadurch gekennzeichnet, daß die Betätigung der Verriegelungsvorrichtung (18, 19) mittels einer Hebeleinrichtung (16, 17, 21, 22) mit der Türhandhabe (20) verbunden ist.

4. Tür nach Anspruch 2 oder 3, dadurch gekennzeichnet, daß die Verriegelungseinrichtung einen Satz erste Verriegelungsteile (17, 18), die in der Tür angeordnet sind und sich in einer zur Türfläche parallelen Ebene in entgegengesetzte Richtungen bewegen, und einen Satz zweite Verriegelungsteile (19) aufweist, die in dem ortsfesten Gebäudeteil angeordnet sind, mit den ersten Verriegelungsteilen zusammenwirken und eine zur Ebene der Türfläche rechtwinklige Kratt erzeugen.

5. Tür nach Anspruch 4, dadurch gekennzeichnet, daß die ersten Verriegelungsteile Laufrollen (18) aufweisen, die an den Enden der Zugstäbe (17) gelagert sind, die sich in einer zur Ebene der Türfläche ebenen Fläche in entgegengesetzte Richtungen bewegen, und daß die zweiten Verriegelungsteile, die mit den ersten Verriegelungsteilen zusammenwirken, Diagonalschlitze (19) aufweisen, die mit dem ortsfesten Gebäudeteil (2) verbunden sind und die Laufrollen (18) führen.

6. Tür nach einem der vorhergehenden Ansprüche, dadurch gekennzeichnet, daß sie mittels Gelenken (7) an dem ortsfesten Gebäudeteil (2) angebracht ist, wobei die Gelenke mit zwei Zapfen versehen sind und eine geradlinige Bewegung zulassen,

7. Tür nach Anspruch 6, dadurch gekennzeichnet, daß die Schwenkbewegung der Tür um einen Zapfen (9) des Gelenkes (7), welches eine geradlinige Bewegung zuläßt, mittels eines federvorgespannten (14) einstellbaren Anschlags (13) begrenzt ist.

## Revendications

1. Porte dans une construction empêchant le passage des champs d'interférence, en particulier des champs électromagnétiques à haute fréquence, dans laquelle construction ladite porte (1) est montée pivotante au moyen d'au moins un ensemble (7) de gonds,
ladite porte (1) et ladite construction fixe (2) étant pourvues d'organes de contact (3, 4, 5) produisant un contact entre ladite porte (1) et ladite construction fixe (2) empêchant le passage des champs d'intérference,
lesdits organes de contact comprenant
une fente (3) pourvue sur le châssis et ayant une section transversale essentiellement rectangulaire,
des ressorts (4) pourvus sur des panneaux de côté internes opposés de ladite fente (3), et
un couteau (5) de contact en forme de lame relié à ladite porte (1) près du bord de celle-ci et susceptible d'insertion dans ladite fente (3),
**caractérisée en ce**
que le déplacement de ladite porte (1) pour l'ouverture ou la fermeture de ladite construction (2) se décompose en deux phases d'une manière connue, l'une phase consistant en un mouvement de pivotement autour d'axes (8) définis par ledit ensemble (7) de gonds et l'autre phase consistant en un déplacement essentiellement linéaire perpendiculaire au châssis de ladite porte (1), et
que lesdits organes de contact comprennent encore un guide (6) en forme de coin relié à ladite porte (1) et susceptible d'insertion dans une seconde fente (3), ledit déplacement essentiellement linéaire étant un déplacement guidé linéaire sans aucun mouvement latéral.

2. Porte selon la revendication 1, caractérisée en ce que le déplacement essentiellement linéaire de la porte (1), lorsqu'il produit le contact qui empêche le passage du champ d'interférence, s'effectue avec guidage par un moyen de verrouillage (18, 19) reliant la porte (1) et la construction fixe (2).

3. Porte selon la revendication 2, caractérisée en ce que le fonctionnement desdits moyens de verrouillage (18, 19) est relié à la poignée (20) de la porte au moyen d'un jeu de leviers (16, 17, 21, 22).

4. Porte selon la revendication 2 ou 3, caractérisée en ce que les moyens de verrouillage comprennent un jeu de premiers organes de verrouillage (17, 18) disposés dans la porte et se déplaçant dans une direction parallèle au plan de la face de celle-ci dans des directions opposées, ainsi qu'un jeu de seconds organes de verrouillage (19) disposés dans la construction fixe, fonctionnant conjointement avec lesdits premiers organes et produisant une force perpendiculaire au plan de la face de la porte.

5. Porte selon la revendication 4, caractérisée en ce que les premiers organes de verrouillage comprennent des galets de roulement (18) montés aux extrémités des axes de traction (17) se déplaçant dans des directions opposées parallèlement au plan de la face de la porte, et en ce que les seconds organes de verrouillage fonctionnant conjointement avec lesdits premiers organes comprennent des fentes diagonales (19) reliées à la construction fixe (2) et guidant les galets de roulement (18).

6. Porte selon l'une quelconque des revendications précédentes, caractérisée en ce qu'elle est montée sur la construction fixe (2) au moyen de gonds (7) pourvus de deux axes permettant un déplacement linéaire.

7. Porte selon la revendication 6, caractérisée en ce que le mouvement de pivotement de la porte autour d'un axe (9) du gond (7) permettant un déplacement linéaire est limité au moyen d'un limiteur réglable (13) sollicité par un ressort (14).

FIG. 1

FIG. 2

FIG. 3

FIG. 4

FIG. 5